# DEMANDE DE BREVET EUROPEEN

(11) **EP 1 944 808 A1**
(43) Date de publication de la demande: **16.07.2008**
(21) Numéro de dépôt: 07123037.9
(22) Date de dépôt: 12.12.2007
(51) Int. Cl.: H01L 27/146, H01L 31/0232

(54) **Module optique imageur destiné à être associé à un composant semi-conducteur optique et procédé pour sa fabrication.**

(30) Priorité: 15.01.2007 FR 0752665
(71) Demandeur: STMICROELECTRONICS SA, 92120 Montrouge (FR)
(72) Inventeur: Vigier-Blanc, Emmanuelle, 38700 Le Sappey en Chartreuse (FR); Cassar, Guillaume, 38000 Grenoble (FR)
(74) Mandataire: Zapalowicz, Francis

(57) **Abrégé**

Module optique imageur destiné à être placé devant un capteur optique d'image d'un composant semi-conducteur, comprenant au moins un élément (7) qui présente un indice de réfraction variant entre son axe optique et sa périphérie, sur au moins une partie annulaire et/ou sur sa partie centrale.

## Description

La présente invention concerne le domaine général des caméras et plus particulièrement le domaine des composants semi-conducteurs incluant des capteurs optiques d'images devant lesquels sont installés des modules optiques imageurs pour projeter des images sur ces capteurs optiques d'images.

I1 est actuellement connu que de tels modules optiques peuvent comprendre une lentille en verre, une pastille en verre placée entre la lentille et le capteur et un diaphragme placé entre la lentille et la pastille. Il est également connu que de tels éléments soient avantageusement empilés les uns sur les autres.

Néanmoins il existe actuellement une limite à l'augmentation du nombre de pixels composant les capteurs optiques car les images captées deviennent floues et/ou moins contrastées.

La présente invention a notamment pour objet d'améliorer le pouvoir de résolution et/ou le contraste des modules optiques imageurs associés à des composants semi-conducteurs optiques, dans le but de pouvoir augmenter la netteté et/ou le contraste des images captées par les composants semi-conducteurs actuellement disponibles et/ou augmenter le nombre de pixels composant les capteurs optiques d'images des composants, sans réduire la netteté et/ou le contraste des images captées.

La présente invention a tout d'abord pour objet un module optique imageur destiné à être placé devant un capteur optique d'image d'un composant semi-conducteur et au travers duquel est projetée une image vers ce capteur optique d'image.

Selon l'invention, ce module peut comprendre au moins un élément qui présente un indice de réfraction variant entre son axe optique et sa périphérie, sur au moins une partie annulaire et/ou sur sa partie centrale.

Selon une variante de l'invention, l'indice de réfraction dudit élément peut avantageusement varier dans un sens.

Selon l'invention, le module optique imageur peut éventuellement comprendre au moins un élément qui présente un indice de réfraction variant entre son axe optique ou sa partie centrale et sa périphérie.

Selon l'invention, le module optique imageur peut éventuellement comprendre au moins un premier élément constitué par une pastille à faces parallèles et un second élément constitué par une lentille optique, au moins l'un de ces éléments présentant un indice de réfraction variant entre son axe optique et sa périphérie, sur au moins une zone annulaire.

Selon l'invention, lesdits éléments peuvent éventuellement présenter des indices de réfraction variant en sens inverse entre leur axe optique ou leur partie centrale et leur périphérie.

Selon l'invention, l'indice de réfraction de ladite pastille peut éventuellement augmenter entre son axe optique ou sa partie centrale et sa périphérie.

Selon l'invention, l'indice de réfraction de ladite lentille peut éventuellement diminuer entre son axe optique ou sa partie centrale et sa périphérie.

La présente invention a également pour objet un procédé de fabrication d'un élément optique imageur destiné à être placé devant un capteur optique d'image d'un composant semi-conducteur et au travers duquel est projetée une image vers ce capteur optique d'image.

Selon l'invention, ce procédé peut comprendre l'étape suivante : doper le matériau constituant ledit élément avec des ions adaptés pour modifier l'indice de réfraction de cet élément, de telle sorte que cet indice varie entre son axe optique ou sa partie centrale et sa périphérie, sur au moins une zone annulaire.

Selon l'invention, le procédé peut éventuellement comprendre l'étape préalable suivante : doper le matériau constituant ledit élément avec des ions différents.

Selon l'invention, le procédé peut éventuellement comprendre, préalablement, une étape de dopage complémentaire du matériau constituant ledit élément avec des ions de dopage préalable ou avec d'autres ions.

Selon l'invention, ledit élément peut éventuellement être en verre et les ions de dopage peuvent éventuellement être choisis parmi les ions de sodium (Na+), de potassium (K+), de lithium (Li+), d'argent (Ag+), de césium (Cs+), de thallium (Tl+).

Selon l'invention, le procédé peut éventuellement comprendre l'étape suivante : doper avec des ions de thallium (T1+) un élément en verre préalablement dopé avec des ions de sodium (Na+).

Selon le procédé de l'invention, ledit élément peut éventuellement être une pastille.

Selon l'invention, le procédé peut éventuellement comprendre l'étape suivante : doper avec des ions de sodium (Na+).un élément en verre préalablement dopé avec des ions thallium (Tl+).

Selon le procédé de l'invention, ledit élément peut éventuellement être une lentille.

Selon l'invention, le procédé peut éventuellement comprendre les étapes suivantes : former sur ledit élément un masque présentant au moins une ouverture annulaire et/ou une ouverture centrale ; doper le matériau constituant cet élément au travers de ce masque ; et enlever ledit masque.

La présente invention a également pour objet un procédé de fabrication d'éléments optiques imageurs destinés à être placés devant des capteurs optiques d'images de composants semi-conducteurs et au travers desquels sont projetées des images vers ces capteurs optiques d'images.

Selon une variante de l'invention, ce procédé peut éventuellement comprendre les étapes suivantes : prendre une plaquette ; réaliser les rainures croisées, éventuellement rectilignes mais pas obligatoirement, dans une face avant de ladite plaquette de façon à former des plots en saillie ; former un masque recouvrant la face arrière de ladite plaquette, les faces d'extrémité desdits plots et le fond desdites rainures ; doper avec des ions le matériau constituant ladite plaquette au travers dudit masque, produisant radialement un dopage de chacun desdits plots ; et enlever ledit masque ; de telle sorte que l'indice de réfraction de chaque plot varie entre son axe optique ou sa partie centrale et sa périphérie.

Selon une autre variante de l'invention, ce procédé peut éventuellement comprendre les étapes suivantes : prendre une plaquette ; former sur une face avant de ladite plaquette un masque comprenant sur des zones de cette face avant une ouverture centrale et/ou au moins une ouverture annulaire ; former un masque recouvrant la face arrière de ladite plaquette ; doper avec des ions le matériau constituant ladite plaquette au travers dudit masque ; et enlever lesdits masques ; de telle sorte que l'indice de réfraction de chaque partie de ladite plaquette correspondant auxdites zones varie entre son axe optique ou sa partie centrale et sa périphérie.

La présente invention a également pour objet une plaquette à faces parallèles comprenant une multiplicité de parties comprenant respectivement des pastilles optiques imageurs destinées à être placées devant des capteurs optiques d'images de composants semi-conducteurs et au travers desquelles sont projetées des images vers ces capteurs optiques d'images, chaque pastille présentant un indice de réfraction variant entre son axe optique et sa périphérie, sur au moins une partie annulaire et/ou sur sa partie centrale.

La présente invention a également pour objet une plaquette comprenant une multiplicité de parties constituant respectivement des lentilles optiques imageurs destinées à être placées devant des capteurs optiques d'images de composants semi-conducteurs et au travers desquelles sont projetées des images vers ces capteurs optiques d'images, chaque lentille optique présentant un indice de réfraction variant entre son axe optique et sa périphérie, sur au moins une partie annulaire et/ou sur sa partie centrale.

La présente invention a également pour objet un dispositif optique imageur comprenant ladite plaquette à pastilles et ladite plaquette à lentilles, accolées l'une à l'autre de façon que lesdits éléments optiques et lesdites lentilles optiques soient placés les uns sur les autres et constituent des modules optiques imageurs.

La présente invention a également pour objet un procédé de fabrication de dispositifs semi-conducteurs optiques.

Ce procédé peut éventuellement comprendre les étapes suivantes : accoler l'une à l'autre ladite plaquette à pastilles et ladite plaquette à lentilles de façon que lesdits éléments optiques et lesdites lentilles optiques soient placés les uns sur les autres et comprennent des modules optiques imageurs ; accoler sur ladite plaquette à pastilles une plaquette comprenant une multiplicité de parties comprenant respectivement des composants semi-conducteurs à capteurs optiques d'images de façon que lesdits modules optiques imageurs et lesdits composants semi-conducteurs soient placés les uns sur les autres ; et sectionner lesdites plaquettes accolées de façon à singulariser une multiplicité de dispositifs semi-conducteurs à capteurs optique d'images comprenant respectivement d'un composant semi-conducteur et d'un module optique imageur.

La présente invention a également pour objet un boîtier semi-conducteur optique.

Ce semi-conducteur optique peut éventuellement comprendre : un composant semi-conducteur comprenant un capteur optique d'image sur sa face avant, un module optique imageur placé devant le capteur optique d'image du composant semi-conducteur et au travers duquel une image est projetée vers ce capteur optique d'image, ledit module optique imageur comprenant au moins un élément qui présente un indice de réfraction variant entre son axe optique et sa périphérie, sur au moins une partie annulaire et/ou sur sa partie centrale.

Selon l'invention, l'indice de réfraction dudit élément dudit boîtier peut éventuellement varier dans un sens.

Selon l'invention, ledit module optique imageur dudit boîtier peut éventuellement comprendre au moins un premier élément comprenant une pastille à faces parallèles placée devant le composant semi-conducteur et un second élément comprenant une lentille optique placé devant ladite pastille, un diaphragme étant interposé entre ladite pastille et ladite lentille au moins l'un de ces éléments présentant un indice de réfraction variant entre son axe optique et sa périphérie, sur au moins une zone annulaire.

Selon l'invention, lesdits éléments dudit boîtier peuvent éventuellement présenter des indices de réfraction variant en sens inverse entre leur axe optique ou leur partie centrale et leur périphérie.

Selon l'invention, l'indice de réfraction de ladite pastille dudit boîtier peut éventuellement augmenter entre son axe optique ou sa partie centrale et sa périphérie.

Selon l'invention, l'indice de réfraction de ladite lentille dudit boîtier peut éventuellement diminuer entre son axe optique ou sa partie centrale et sa périphérie.

La présente invention sera mieux comprise à l'étude d'éléments et de modules optiques destinés à être placés devant un capteur optique d'un composant semi-conducteur, ainsi que leurs modes de fabrication, décrits à titre d'exemples non-limitatifs et illustrés par le dessin sur lequel :
- La figure 1 représente une coupe axiale d'un boîtier incluant un module optique selon l'invention ;
- La figure 2 représente une vue en perspective d'une plaquette de pastilles ;
- La figure 3 représente une coupe d'une portion de la plaquette de la figure 2, selon une première étape de traitement ;
- La figure 4 représente une vue de dessus de la portion de la figure 3 ;
- La figure 5 représente la portion de la figure 3, selon une étape suivante de traitement ;
- La figure 6 représente la portion de la figure 3, après une étape ultime de traitement ;
- La figure 7 représente une coupe d'une portion de la plaquette de la figure 2, selon une première étape d'un autre traitement ;
- La figure 8 représente une vue de dessus de la portion de la figure 7 ;
- La figure 9 représente la portion de la figure 7, selon une étape suivante de traitement ;
- La figure 10 représente la portion de la figure 7, selon une étape suivante de traitement ;
- La figure 11 représente la portion de la figure 3, après une étape ultime de traitement ;
- La figure 12 représente une vue en coupe d'une plaquette de lentilles optiques ;
- La figure 13 représente une coupe d'une portion de la plaquette de la figure 12, selon une première étape de traitement ;
- La figure 14 représente une vue de dessus de la portion de la figure 13 ;
- La figure 15 représente la portion de la figure 12, selon une étape suivante de traitement ; 1
- a figure 16 représente la portion de la figure 12, après une étape ultime de traitement ;
- La figure 17 représente un assemblage des portions de figures 11 et 16 ;
- Et la figure 18 représente un montage de l'assemblage de la figure 17 sur une plaquette de composants semi-conducteurs.

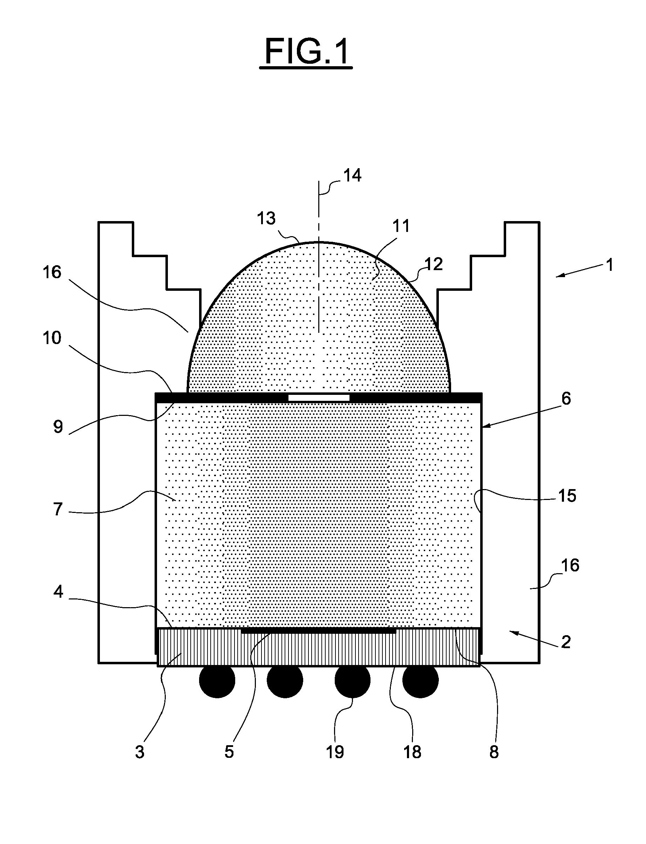

En se reportant à la figure 1, on voit qu'on a représenté un boîtier semi-conducteur optique 1 qui comprend un empilage 2 comprenant d'un composant semi-conducteur 3 qui présente sur sa face avant 4 un capteur optique d'image 5, et d'un module optique imageur 6.

Selon la présente description, un capteur optique d'image est apte à capter une ou des images d'une scène se produisant en avant dudit boîtier. Un tel capteur d'image comprend généralement une multiplicité de photodiodes élémentaires transformant respectivement un flux de photons en un signal électrique, constituant des pixels.

Selon la présente description, un module optique imageur 6 est un organe optique au travers duquel un capteur optique d'image voit ladite scène.

Le module optique imageur 6 comprend une pastille transparente 7 de préférence en verre, dont la face arrière 8 et la face avant 9 sont parallèles, un diaphragme 10 et une lentille frontale convergente 11 de préférence en verre, dont la face arrière 12 est plate et la face avant 13 est bombée par exemple de façon hémisphérique, le diaphragme 10 étant interposé entre la face avant 9 de la pastille 7 et la face arrière 12 de la lentille 11.

Le capteur optique d'image 5, la pastille transparente 7, le diaphragme 10 et la lentille 11 présentent le même axe optique 14.

L'empilage 2 est logé axialement dans un passage traversant 15 5 d'un carter opaque 16, la lentille passant au travers d'un épaulement intérieur 17 de ce passage, formant une butée avant pour la pastille 7. La face arrière 18 du composant semi-conducteur 3 est munie de billes 19 de connexion électrique extérieure.

La pastille 7 présente un indice de réfraction variant entre son axe optique et sa périphérie, sur au moins une partie annulaire et/ou sur sa partie centrale.

Dans l'exemple décrit, l'indice de réfraction de la pastille 6 croît substantiellement de façon progressive entre l'axe optique 14 ou sa partie centrale et sa périphérie.

La lentille 11 présente un indice de réfraction variant entre son axe optique et sa périphérie, sur au moins une partie annulaire et/ou sur sa partie centrale.

Dans l'exemple décrit, l'indice de réfraction de la lentille 11 décroît substantiellement de façon progressive entre l'axe optique 14 ou sa partie centrale et sa périphérie,

Pour obtenir la pastille 7 et la lentille 11 présentant de tels indices de réfraction variables, on peut procéder à un dopage adapté du verre avec des ions métalliques choisis parmi, par exemple, les ions de sodium (Na⁺), de potassium (K⁺), de lithium (Li⁺), d'argent (Ag⁺), de césium (Cs⁺), ou de thallium (Tl⁺).

On va maintenant décrire, en exemples, comment on peut fabriquer une multiplicité de pastilles 7.

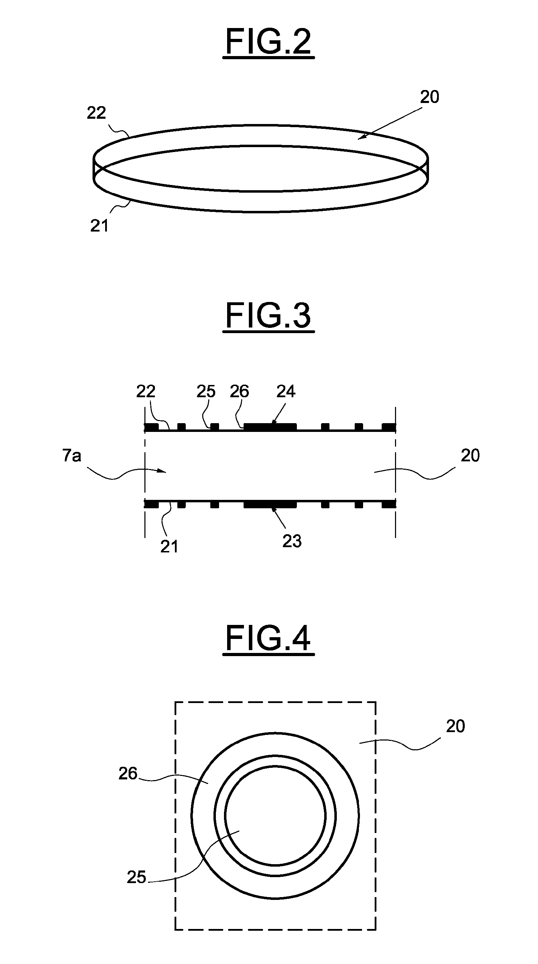

Comme le montre la figure 2, on peut partir d'une plaquette 20 en verre, de grande dimension. Cette plaquette est par exemple préalablement dopée substantiellement uniformément dans sa masse par exemple avec des ions de thallium (Tl+), par exemple en la plongeant dans un bain de nitrate de thallium (TlNO3) et sous l'effet d'un champ électrique accélérateur orienté dans le sens de son épaisseur.

Les figures 3 à 6 illustrent une première manière de procéder.

Comme le montrent les figures 3 et 4, on réalise sous forme de couches par exemple par dépôt, sur les faces 21 et 22 de la plaquette 20, des masques opposés 23 et 24 se correspondant dans le sens de l'épaisseur de cette plaquette. Ces masques sont tels que, sur des parties 7a de la plaquette 20 destinées à constituer ultérieurement des pastilles 7, sont prévues une ouverture centrale 25 et une ouverture annulaire 26, ces parties 7a étant réparties selon une matrice carrée.

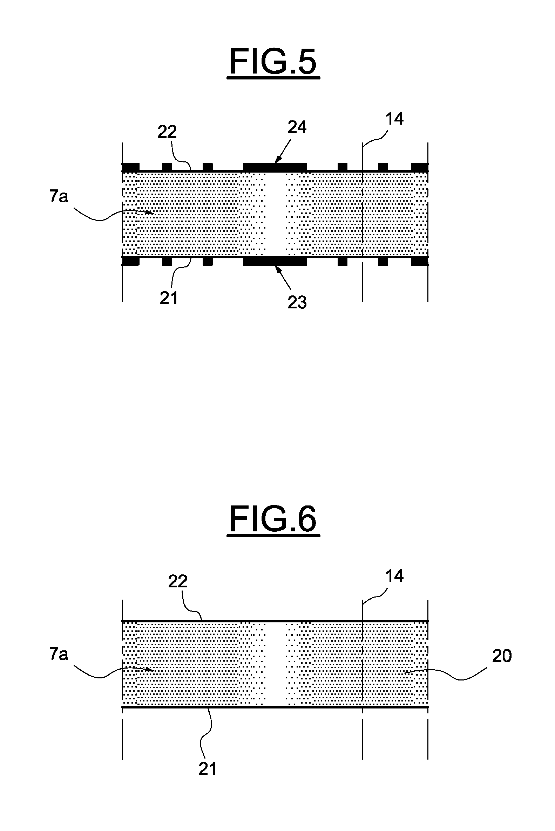

Après quoi, comme le montre la figure 5, on procède, au travers des masques 23 et 24, à un dopage de la plaquette 20 par exemple avec des ions de sodium (Na+), par exemple en la plongeant dans un bain de nitrate de sodium (NaNO3) et sous l'effet d'un champ électrique accélérateur orienté dans le sens de son épaisseur.

Les masques 23 et 24 et le dopage ci-dessus sont adaptés de telle sorte que la densité d'ions Na+ contenus dans le matériau décroisse de façon substantielle entre l'axe 14 de chaque partie 7a ou sa partie centrale et sa périphérie.

Ensuite, comme le montre la figure 6, on procède à l'enlèvement des masques 23 et 24.

Il résulte du traitement décrit ci-dessus que l'indice de réfraction de chaque partie 7a de la plaquette 20 augmente entre respectivement leur axe optique 14 ou leur partie centrale et leur périphérie, selon un gradient radial déterminé par la variation radiale de la densité des ions de dopage dans le verre.

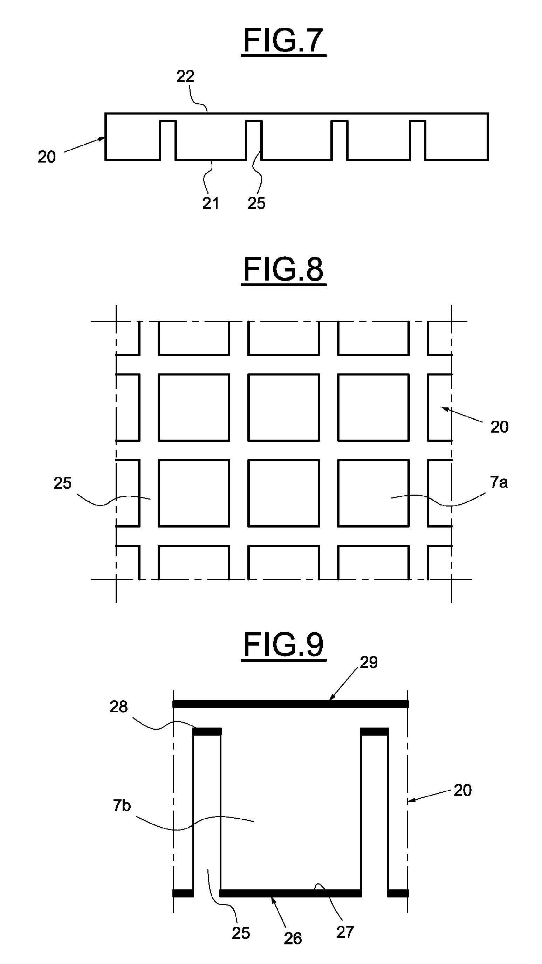

Les figures 7 à 11 illustrent une deuxième manière de traiter la plaquette 20.

Comme le montrent les figures 7 et 8, on réalise dans la face avant 21 de la plaquette 20 des rainures croisées 25, de façon à constituer des plots 7b en saillie par rapport à la faible épaisseur restante, ces plots étant destinés à constituer ultérieurement des pastilles 7 et étant répartis selon une matrice carrée. Les rainures croisées 25 peuvent être réalisées de façon à former des plots en saillie de formes quelconques, par exemple carrés ou circulaires.

Ensuite, comme le montre la figure 9, on réalise sous forme de couches par exemple par dépôt, un masque 26 qui recouvre les faces d'extrémité 27 des plots 7b et le fond 28 des rainures croisées 25 et un masque 29 qui recouvre complètement la face arrière 22 de la plaquette 20. Ainsi, les flancs des plots 26 sont découverts.

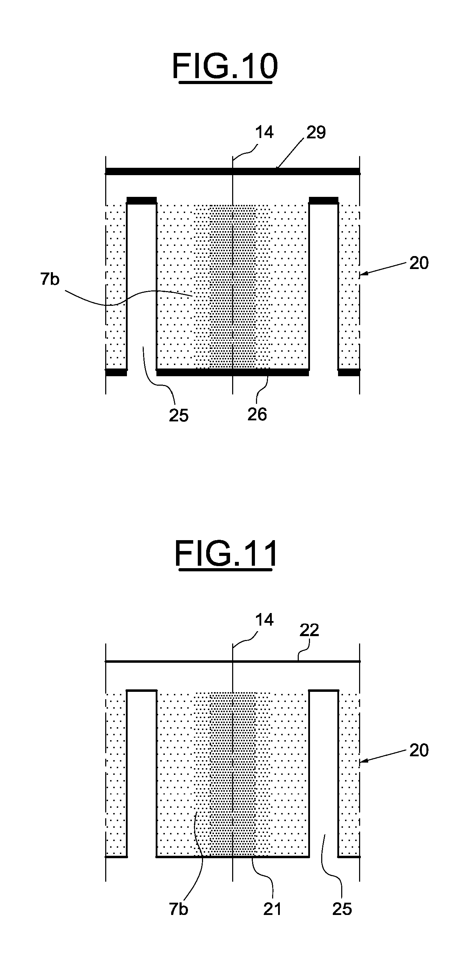

Après quoi, comme le montre la figure 10, on procède à un dopage radial des plots 7b de la plaquette 20, via leurs flancs découverts, par exemple avec des ions de thallium (Tl+), par exemple en plongeant la plaquette 20 dans un bain de nitrate de thallium (TlNO3).

Le dopage ci-dessus est adapté de telle sorte que la densité d'ions Tl+ contenus dans le matériau croisse de façon substantielle entre la périphérie de chaque plot 7b et leur partie centrale ou leur axe 14.

Ensuite, comme le montre la figure 11, on procède à l'enlèvement des masques 26 et 29.

Il en résulte que l'indice de réfraction de chaque plot 7b de la plaquette 20 augmente entre son axe optique 14 ou sa partie centrale et sa périphérie, selon un gradient radial déterminé par la variation radiale de la densité des ions de dopage dans le verre.

Selon une autre variante, on pourrait, de façon complémentaire, doper dans la croûte la partie périphérique des plots 7a avec des ions de sodium (Na+), de façon à réduire légèrement l'indice de réfraction dans l'extrême partie périphérique des plots 7a, par rapport à l'augmentation ci-dessus.

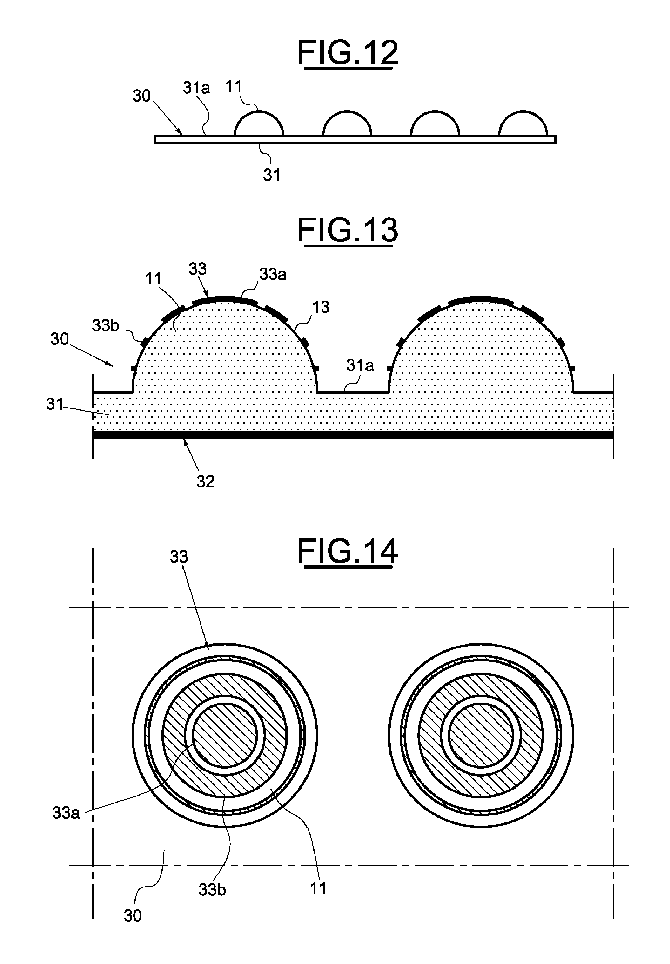

En référence aux figures 12 à 16, on va maintenant décrire, en exemple, comment on peut fabriquer une multiplicité de lentilles 11.

Comme le montre la figure 12, on peut partir d'une plaquette 30 en verre, de grande dimension qui présente un disque 31 sur sur une face avant 31 a duquel sont formées des lentilles 11 en saillie sur ce disque, espacées et réparties selon une matrice carrée, par exemple hémisphériques.

On procède alors à un dopage préalable, dans sa masse, de la plaquette 30 par exemple avec des ions de thallium (Tl+), par exemple en la plongeant dans un bain de nitrate de thallium (TlNO3).

Ensuite, comme le montrent les figures 13 et 14, on réalise sous formes de couches par exemple par dépôt, un masque 32 qui recouvre la face plate de la plaquette 30 et une multiplicité de masques 33 qui recouvrent partiellement les faces bombées 13 des lentilles 11, chaque masque 33 comprenant une partie centrale ronde 33a et des parties annulaires espacées 33b laissant découvertes entre elles des zones annulaires à partir de cette partie centrale ronde.

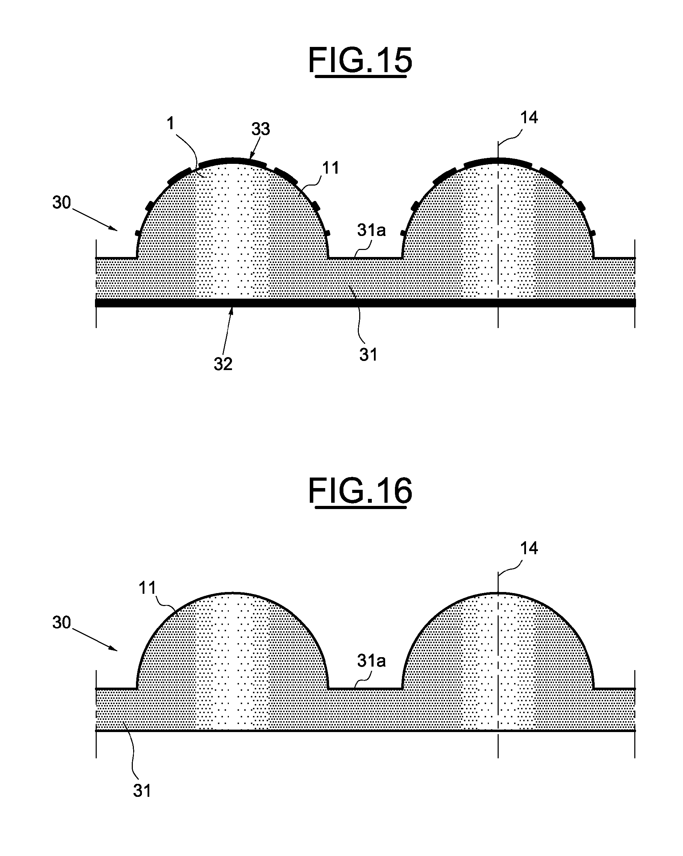

Après quoi, comme le montre la figure 15, on procède, à un dopage de la plaquette 30 par exemple avec des ions de sodium (Na+), par exemple en la plongeant dans un bain de nitrate de sodium (NaNO3).

Le dopage ci-dessus est adapté de telle sorte que la densité d'ions Na+ contenus dans le matériau croisse de façon substantielle entre la partie centrale ou l'axe 14 et la périphérie de chaque lentille 11.

Ensuite, comme le montre la figure 16, on procède à l'enlèvement des masques 32 et 33.

Il en résulte que l'indice de réfraction de chaque lentille 11 de la plaquette 30 diminue entre leur axe optique 14 ou leur partie centrale et leur périphérie, selon un gradient radial déterminé par la variation radiale de la densité des ions de dopage dans le verre.

On va maintenant décrire comment on peut fabriquer une multiplicité de modules optiques imageurs 6 à partir des plaquettes 20 et 30, traitées comme décrit précédemment.

On réalise, par exemple par dépôt, une couche 34 sur la face 22 de la plaquette 20, en ménageant des ouvertures 10a centrées sur les axes optiques 14 des parties 7a dans le cas de la première variante ou des plots 7b dans le cas de la deuxième variante, de façon à constituer une multiplicité de diaphragmes 10.

Ensuite, on accole la face plate de la plaquette 30 sur la couche 34, par l'intermédiaire d'une colle transparente, de façon que les axes optiques des parties 7a dans le cas de la première variante ou des plots 7b dans le cas de la deuxième variante correspondent aux axes optiques des lentilles 11.

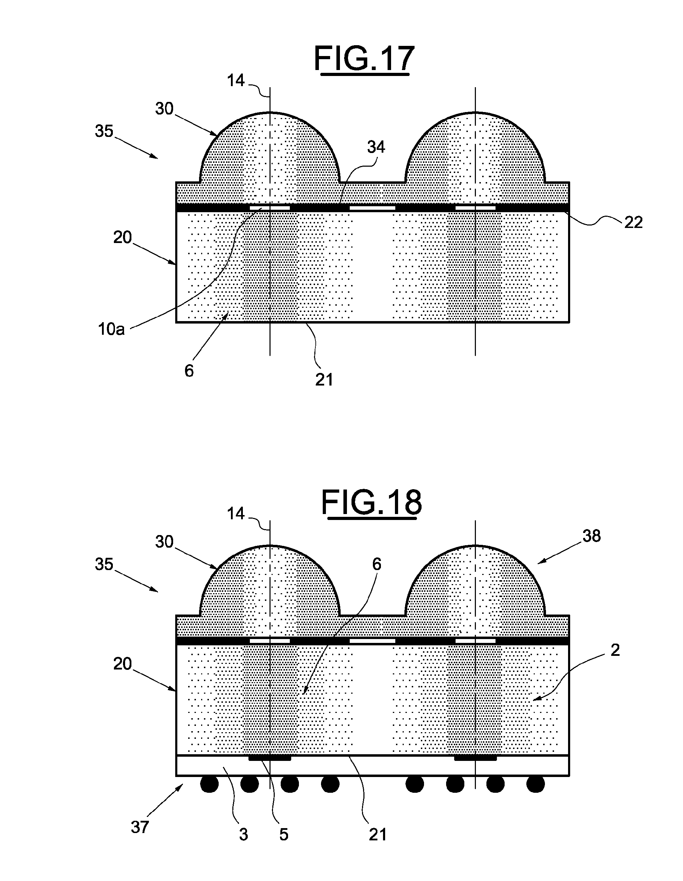

On obtient ainsi, comme le montre la figure 17, une plaquette 35 comprenant une multiplicité de modules optiques imageurs 6 répartis selon une matrice carrée.

Disposant d'une plaquette 37 comprenant une multiplicité de composants semi-conducteurs 3 répartis selon une matrice carrée, on accole cette plaquette 37 sur la face 21 de la plaquette 20 incluse dans la plaquette 35 de façon que les axes optiques des modules optiques imageurs 6 correspondent aux axes optiques des capteurs 5 des composants semi-conducteurs 3.

On obtient ainsi comme le montre la figure 18, une plaquette 38 comprenant une multiplicité d'empilage 2.

Ensuite, on procède au sciage de cette plaquette 38 de façon à séparer et singulariser chacun des empilages 2, constitué chacun d'un composant semi-conducteur 3 et d'un module optique imageur 6, comme décrit en référence à la figure 1.

A titre exemple, d'une part la pastille 7 peut présenter une largeur comprise entre 3 et 5 mm et une épaisseur comprise entre 1 et 3 mm et d'autre part la lentille 11 peut présenter un rayon compris entre 1,3 et 1,7 mm et une épaisseur comprise entre 0,5 et 1,5mm.

De plus, la variation de l'indice de réfraction de la pastille 7 et, à l'inverse, de la lentille 11, entre sa partie centrale et sa partie périphérique peut en pourcentage, être comprise entre 4 et 9%. A titre uniquement d'exemple, cette variation peut présenter la forme d'une paraboloïde dont le sommet serait environ à la moitié du rayon de la pastille ou de la lentille.

La présente invention ne se limite pas aux exemples décrits. Elle s'applique aussi à tout empilement d'un nombre quelconque de lentilles et/ou de pastilles séparées ou non par de l'air, contenant au moins un élément présentant un gradient d'indice non nul, notamment radial.

## Revendications

1. Module optique imageur destiné à être placé devant un capteur optique d'image d'un composant semi-conducteur et au travers duquel est projetée une image vers ce capteur optique d'image, **caractérisé par le fait qu'**il comprend au moins un élément (7) qui présente un indice de réfraction variant entre son axe optique et sa périphérie, sur au moins une partie annulaire et/ou sur sa partie centrale.

2. Module selon la revendication 1, **caractérisé par le fait que** l'indice de réfraction dudit élément varie dans un sens.

3. Module selon l'une des revendications 1 et 2, **caractérisé par le fait qu'**il comprend au moins un élément qui présente un indice de réfraction variant entre son axe optique ou sa partie centrale et sa périphérie.

4. Module selon l'une quelconque des revendications précédentes, **caractérisé par le fait qu'**il comprend au moins un premier élément (7) constitué par une pastille à faces parallèles et un second élément (11) constitué par une lentille optique, au moins l'un de ces éléments présentant un indice de réfraction variant entre son axe optique et sa périphérie, sur au moins une zone annulaire.

5. Module selon la revendication 4, **caractérisé par le fait que** lesdits éléments présentent des indices de réfraction variant en sens inverse entre leur axe optique ou leur partie centrale et leur périphérie.

6. Module selon l'une des revendications 4 et 5, dans lequel l'indice de réfraction de ladite pastille augmente entre son axe optique ou sa partie centrale et sa périphérie.

7. Module selon l'une quelconque des revendications 4 à 6, dans lequel l'indice de réfraction de ladite lentille diminue entre son axe optique ou sa partie centrale et sa périphérie.

8. Procédé de fabrication d'un élément optique imageur destiné à être placé devant un capteur optique d'image d'un composant semi-conducteur et au travers duquel est projetée une image vers ce capteur optique d'image, comprenant l'étape suivante : doper le matériau constituant ledit élément avec des ions adaptés pour modifier l'indice de réfraction de cet élément, de telle sorte que cet indice varie entre son axe optique ou sa partie centrale et sa périphérie, sur au moins une zone annulaire.

9. Procédé selon la revendication 8, comprenant l'étape préalable suivante : doper le matériau constituant ledit élément avec des ions différents.

10. Procédé selon l'une des revendications 8 et 9, comprenant l'étape suivante : effectuer un dopage complémentaire du matériau constituant ledit élément avec des ions de dopage préalable ou avec d'autre ions.

11. Procédé selon l'une quelconque des revendications 8 à 10, dans lequel ledit élément est en verre et les ions de dopage sont choisis parmi les ions de sodium (Na⁺), de potassium (K⁺), de lithium (Li⁺), d'argent (Ag⁺), de césium (Cs⁺), de thallium (Tl⁺).

12. Procédé selon la revendication 8, comprenant l'étape suivante : doper avec des ions de thallium (Tl⁺) un élément en verre préalablement dopé avec des ions de sodium (Na⁺).

13. Procédé selon la revendication 12, **caractérisé par le fait que** ledit élément est une pastille (7).

14. Procédé selon la revendication 8, comprenant l'étape suivante : doper avec des ions de sodium (Na⁺). un élément en verre préalablement dopé avec des ions thallium (Tl⁺).

15. Procédé selon la revendication 14, **caractérisé par le fait que** ledit élément est une lentille (11).

16. Procédé selon l'une quelconque des revendications 8 à 15, comprenant les étapes suivantes :
former sur ledit élément un masque (26, 29 ; 32, 33) présentant au moins une ouverture annulaire et/ou une ouverture centrale ;
doper le matériau constituant cet élément au travers de ce masque ;
et enlever ledit masque.

17. Procédé de fabrication d'éléments optiques imageurs destinés à être placés devant des capteurs optiques d'images de composants semi-conducteurs et au travers desquels sont projetées des images vers ces capteurs, comprenant les étapes suivantes :
prendre une plaquette (20) ;
réaliser les rainures croisées (25), éventuellement rectilignes, dans une face avant de ladite plaquette de façon à former des plots (7b) en saillie ;
former un masque (26, 29) recouvrant la face arrière de ladite plaquette, les faces d'extrémité desdits plots et le fond desdites rainures ;
doper avec des ions le matériau constituant ladite plaquette au travers dudit masque, produisant radialement un dopage de chacun desdits plots;
et enlever ledit masque ;
de telle sorte que l'indice de réfraction de chaque plot varie entre son axe optique ou sa partie centrale et sa périphérie.

18. Procédé de fabrication d'éléments optiques imageurs destinés à être placés devant des capteurs optiques d'images de composants semi-conducteurs et au travers desquels sont projetées des images vers ces capteurs optiques d'images, comprenant les étapes suivantes :
prendre une plaquette (30) ;
former sur une face avant de ladite plaquette un masque (33) comprenant sur des zones de cette face avant une ouverture centrale et/ou au moins une ouverture annulaire ;
former un masque (32) recouvrant la face arrière de ladite plaquette ;
doper avec des ions le matériau constituant ladite plaquette au travers dudit masque ;
et enlever lesdits masques ;
de telle sorte que l'indice de réfraction de chaque partie de ladite plaquette correspondant auxdites zones varie entre son axe optique ou sa partie centrale et sa périphérie.

19. Plaquette à faces parallèles comprenant une multiplicité de parties constituant respectivement des pastilles optiques d'imageurs destinées à être placées devant des capteurs optiques d'images de composants semi-conducteurs et au travers desquelles sont projetées des images vers ces capteurs optiques d'images, chaque pastille présentant un indice de réfraction variant entre son axe optique et sa périphérie, sur au moins une partie annulaire et/ou sur sa partie centrale.

20. Plaquette comprenant une multiplicité de parties constituant respectivement des lentilles optiques d'imageurs destinées à être placées devant des capteurs optiques d'images de composants semi-conducteurs et au travers desquelles sont projetées des images vers ces capteurs optiques d'images, chaque lentille optique présentant un indice de réfraction variant entre son axe optique et sa périphérie, sur au moins une partie annulaire et/ou sur sa partie centrale.

21. Dispositif optique imageur comprenant la plaquette à pastilles (20) selon la revendication 19 et la plaquette à lentilles (30) selon la revendication 20, accolées l'une à l'autre de façon que lesdits éléments optiques et lesdites lentilles optiques soient placés les uns sur les autres et comprennent des modules optiques imageurs.

22. Procédé de fabrication de dispositifs semi-conducteurs optiques, comprenant les étapes suivantes :
accoler l'une à l'autre la plaquette à pastilles (20) selon la revendication 19 et la plaquette à lentilles (30) selon la revendication 20 de façon que lesdits éléments optiques et lesdites lentilles optiques soient placés les uns sur les autres et comprennent des modules optiques imageurs ;
accoler sur ladite plaquette à pastilles une plaquette (37) comprenant une multiplicité de parties comprenant respectivement des composants semi-conducteurs à capteurs optiques d'images de façon que lesdits modules optiques imageurs et lesdits composants semi-conducteurs soient placés les uns sur les autres, dans une position telle que ces modules optiques imageurs soient placés en face des capteurs optiques d'images de ces composants semi-conducteurs ;
et sectionner lesdites plaquettes accolées de façon à singulariser une multiplicité de dispositifs semi-conducteurs comprenant respectivement d'un composant semi-conducteur à capteur optique d'image et d'un module optique imageur.

23. Boîtier semi-conducteur optique comprenant :
un composant semi-conducteur comprenant un capteur optique d'image sur sa face avant,
un module optique imageur placé devant le capteur optique d'image du composant semi-conducteur et au travers duquel une image est projetée vers ce capteur optique d'image,
ledit module optique imageur comprenant au moins un élément qui présente un indice de réfraction variant entre son axe optique et sa périphérie, sur au moins une partie annulaire et/ou sur sa partie centrale.

24. Boîtier semi-conducteur optique selon la revendication 23, **caractérisé par le fait que** l'indice de réfraction dudit élément varie dans un sens.

25. Boîtier semi-conducteur optique selon l'une des revendications 23 et 24, **caractérisé par le fait que** ledit module optique imageur comprend au moins un premier élément (7) comprenant une pastille à faces parallèles placée devant le composant semi-conducteur et un second élément (11) comprenant une lentille optique placé devant ladite pastille, un diaphragme étant interposé entre ladite pastille et ladite lentille au moins l'un de ces éléments présentant un indice de réfraction variant entre son axe optique et sa périphérie, sur au moins une zone annulaire.

26. Boîtier semi-conducteur optique selon la revendication 25, **caractérisé par le fait que** lesdits éléments présentent des indices de réfraction variant en sens inverse entre leur axe optique ou leur partie centrale et leur périphérie.

27. Boîtier semi-conducteur optique selon la revendication 25, **caractérisé par le fait que** l'indice de réfraction de ladite pastille augmente entre son axe optique ou sa partie centrale et sa périphérie.

28. Boîtier semi-conducteur optique selon la revendication 25, **caractérisé par le fait que** l'indice de réfraction de ladite lentille diminue entre son axe optique ou sa partie centrale et sa périphérie.
